# EUROPÄISCHE PATENTANMELDUNG

(11) **EP 0 953 986 A2**
(43) Veröffentlichungstag der Anmeldung: **03.11.1999**
(21) Anmeldenummer: 99105689.6
(22) Anmeldetag: 19.03.1999
(51) Int. Cl.: G11C 29/00

(54) **Anordnung zum Testen mehrerer Speicherchips auf einem Wafer**

(30) Priorität: 30.04.1998 DE 19819570
(71) Anmelder: SIEMENS AKTIENGESELLSCHAFT, 80333 München (DE)
(72) Erfinder: Haerle, Dieter, 81541 München (DE); Heyne, Patrick, 81541 München (DE); Buck, Martin, 81243 München (DE)

(57) **Zusammenfassung**

Die Erfindung betrifft eine Anordnung zum Testen mehrerer Speicherchips (1) auf einem Wafer, bei der unter Verwendung von Nadeln (6) den Speicherchips (1) Versorgungsspannungen (VDD, VSS), ein Initialisierungssignal (I), ein Auslesesignal (CS), ein Taktsignal (CLK) sowie Adressen-, Daten- und Steuersignale zugeführt sind. Die Adressen-, Daten- und Steuersignale werden dabei von einer im Kerf (2) des Speicherchips angeordneten Logik (5) erzeugt und den Speicherchips (1) direkt zugeführt.

## Beschreibung

Die vorliegende Erfindung betrifft eine Anordnung zum Testen mehrerer Speicherchips auf einem Wafer, bei der unter Verwendung von Nadeln Speicherchips Versorgungsspannungen, ein Initialisierungssignal, ein Auslesesignal, ein Taktsignal sowie Adreß-, Daten- und Steuersignale zugeführt sind.

Bisher werden Chips von beispielsweise 64 Mbit DRAMs in kleinen Gruppen mittels Nadeln von Nadelkarten getestet. Dabei bereitet es Probleme, eine Nadelkarte mit genügend Nadeln herzustellen, um eine Vielzahl von Chips - bevorzugt alle Chips eines Wafers - mit den Nadeln für einen Testlauf zu kontaktieren.

Die obere Grenze von Nadeln auf einer Nadelkarte liegt derzeit bei etwa 1000 Nadeln. Damit lassen sich in der Größenordnung von etwa 20 bis 50 Chips testen, da jedem einzelnen Chip über die Nadeln verschiedene Adressen-, Daten-Versorgungs- und Steuersignale zugeführt werden müssen.

Bekannte Anordnungen sehen also Nadelkarten mit bis zu 1000 Nadeln vor, mit denen gleichzeitig etwa 20 bis 50 Chips getestet werden können. Problematisch ist dabei auch der relativ große Anpreßdruck, der durch die 1000 Nadeln auf die 50 bis 20 Chips ausgeübt wird. Auch ist es schwierig, eine so große Anzahl von Nadeln für jeden Chip, die in der Größenordnung von 50 Nadeln je Chip liegt, an ihren Spitzen koplanar zu gestalten, so daß jeder einzelne Chip auf dem Wafer zuverlässig getestet werden kann.

Es ist daher Aufgabe der vorliegenden Erfindung, eine Anordnung zum Testen mehrerer Speicherchips auf einem Wafer zu schaffen, mit der es möglich ist, wesentlich mehr Speicherchips als bisher in einem Testlauf mit einer Nadelkarte zu testen.

Diese Aufgabe wird bei einer Anordnung der eingangs genannten Art erfindungsgemäß dadurch gelöst, daß wenigstens einige aus den Adreß-, Daten- und Steuersignalen in einer im Kerf (Sägerand, enthaltend Teststrukturen und Zentrierungshilfen der Masken) des Speicherchips angeordneten Logik erzeugt und den Speicherchips direkt zugeführt sind. Bevorzugt werden dabei alle Adreß-Daten- und Steuersignale in dieser im Kerf vorgesehenen Logik erzeugt. Es sei angemerkt, daß unter mehreren Speicherchips auch einzelne Speicherchips zu verstehen sind, wie z.B. zwei durch einen Kerf getrennte Speicherchips.

Die Erfindung beschreitet damit einen vom bisherigen Stand der Technik vollkommen abweichenden Weg: anstelle Verbesserungen in den Nadelkarten bzw. Nadeln anzustreben, was an sich im Zuge der Entwicklung liegen würde, wird eine gesonderte Logik im Kerf des Speicherchips untergebracht, mit deren Hilfe Adressen-, Daten- und Steuersignale lokal im Kerf für jeden Speicherchip erzeugt und direkt diesem zugeführt werden. Dies hat den wesentlichen Vorteil, daß dann nur noch Versorgungsspannungen und wenige codierte Ausgangssignale für jeden Speicherchip über die Nadelkarte zugeführt zu werden brauchen. Das heißt, es sind so über die Nadelkarte lediglich noch fünf Kontaktierungen für die Versorgungsspannungen, ein Initialisierungssignal, ein Auslesesignal und ein Taktsignal erforderlich, so daß mit einer Nadelkarte mit etwa 1000 Nadeln bis zu 200 Chips getestet werden können.

Die im Kerf verlegte lokale Logik für die einzelnen Speicherchips erzeugt somit alle benötigten Adressen-, Daten- und Steuersignale und wertet diese aus. Tritt ein Fehler auf, so wird ein Fehlersignal ausgegeben, das am Testgerät meldet, daß ein Fehler aufgetreten ist. Über entsprechend codierte Signale läßt sich ohne weiteres feststellen, wo dieser Fehler liegt. Bei vier gleichzeitig geboosteten Wortleitungen werden hierfür beispielsweise zwei codierte Signale benötigt. Über den Zeitpunkt, wann ein Fehler aufgetreten ist und die n codierten Signale kann dann der genaue Fehlerort festgelegt werden.

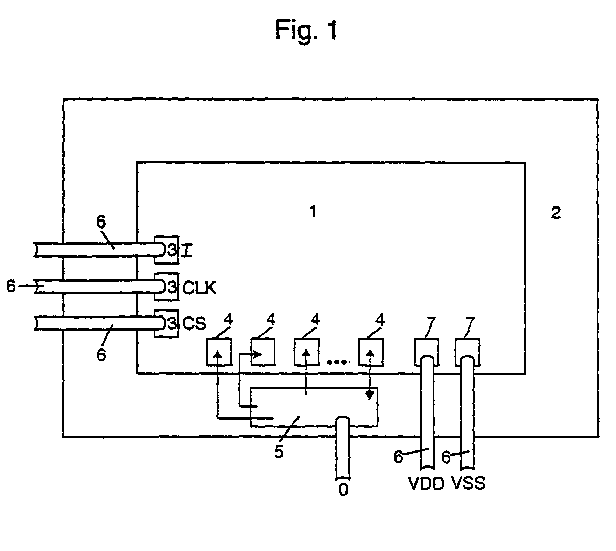

Nachfolgend wird die Erfindung anhand der Zeichnung näher erläutert, in deren einziger Figur eine Draufsicht auf einen Speicherchip mit Kerf gezeigt ist.

Die einzige Figur stellt einen Speicherchip 1 dar, der von einem Kerf bzw. Sägerand 2 umgeben ist. Dieser Kerf 2 fällt beim Zerlegen des Wafers in die einzelnen Speicherchips 1 durch Sägen weg, so daß nach diesem Zerlegen lediglich die einzelnen Speicherchips 1 ohne den Kerf 2 zurückbleiben.

Der Speicherchip 1 ist mit verschiedenen Pads (Kontaktkissen) 3, 4, 7 versehen, die mit Nadeln einer Nadelkarte beim Testdurchlauf kontaktiert werden. So sind Pads 3 für ein Initialisierungssignal I, ein Taktsignal CLK und ein Select- bzw. Wählsignal CS und Pads 7 für Versorgungsspannungen VDD bzw. VSS vorhanden. Außerdem hat der Speicherchip 1 die Pads 4, die mit Nadeln für Adressen-, Daten- und Steuersignale kontaktiert werden. Zur Vereinfachung sind in der Figur lediglich drei solche Pads 4 gezeigt, obwohl tatsächlich bei einem Testdurchlauf beispielsweise elf Adressensignale, acht bis sechzehn Datensignale und fünf Steuersignale anzulegen sind. Dadurch wird, wie bereits oben erläutert wurde, eine Vielzahl von Nadeln benötigt, so daß nur relativ wenige Speicherchips in einer Gruppe gemeinsam mit einer etwa 1000 Nadeln aufweisenden Nadelkarte getestet werden können.

Erfindungsgemäß ist nun im Kerf 2 eine Logik 5 vorgesehen, die mit einem Ausgang O verbunden ist und die Adressen-, Daten- und Steuersignale direkt an die Pads 4 abgibt. Für diese Pads 4 werden daher keine Nadeln mehr benötigt, so daß die Anzahl der für das Testen eines Speicherchips 1 erforderlichen Nadeln erheblich reduziert werden kann.

Die Nadeln sind schematisch gezeigt und mit dem Bezugszeichen 6 versehen, obwohl diese tatsächlich im wesentlichen senkrecht zur Zeichenebene auf die Pads 3 hinzu verlaufen.

Die Logik 5 übernimmt also die Funktion des Testens mit Adressen-, Daten- und Steuersignalen, so daß die Anzahl der insgesamt benötigten Nadeln entsprechend reduziert ist. Selbstverständlich ist es auch möglich, nur einige dieser Signale über die Logik 5 dem Speicherchip 1 zuzuführen.

Nach dem Testdurchlauf wird der Kerf 2 durch Sägen entfernt, wodurch auch die dann nicht mehr benötigte Logik 5 abgetrennt wird.

Die Erfindung nutzt also in vorteilhafter Weise den durch den Kerf gegebenen Platz aus, um hier mit Hilfe der zusätzlichen Logik 5 für eine Reduzierung der Anzahl der benötigten Nadeln 6 zu sorgen.

Die Logik 5 kann gegebenenfalls auch so im Kerf angeordnet werden, daß sie mehrere Halbleiterchips mit den entsprechenden Adressen-, Daten- und Steuersignalen versorgt, so daß beispielsweise eine Logik 5 zwei oder auch mehreren Speicherchips 1 zugeordnet ist.

Auch ist es möglich, bei der erfindungsgemäßen Anordnung die Anzahl der Nadeln einer Nadelkarte zu erhöhen, da die Nadeln selbst weiter voneinander beabstandet angeordnet werden können, was darauf beruht, daß für einen einzelnen Speicherchip weniger Nadeln benötigt werden.

## Patentansprüche

1. Anordnung zum Testen mehrerer Speicherchips (1) auf einem Wafer, bei der unter Verwendung von Nadeln (6) den Speicherchips (1) Versorgungsspannungen (VDD, VSS), ein Initialisierungssignal (I), ein Auslesesignal (CS), ein Taktsignal (CLK) sowie Adressen-, Daten- und Steuersignale zugeführt sind,
**dadurch gekennzeichnet,**
daß wenigstens ein Teil der Adressen-, Daten- und Steuersignale in einer im Kerf (Sägerand) (2) des Speicherchips (1) angeordnete Logik (5) erzeugt und den Speicherchips (1) direkt zugeführt sind.

2. Anordnung nach Anspruch 1,
**dadurch gekennzeichnet,**
daß die Adressen-, Daten- und Steuersignale alle in der Logik (5) erzeugt und den Speicherchips (1) direkt zugeführt sind.
